# EUROPEAN PATENT SPECIFICATION

(11) **EP 2 590 228 B1**
(45) Date of publication and mention of the grant of the patent: **17.02.2021**
(21) Application number: 11800907.5
(22) Date of filing: 29.06.2011
(51) Int. Cl.: H01L 31/042

(54) **SOLAR CELL MODULE AND METHOD FOR MANUFACTURING SAME**
SOLARZELLENMODUL UND VERFAHREN ZU SEINER HERSTELLUNG
MODULE DE CELLULE SOLAIRE ET SON PROCÉDÉ DE FABRICATION

(30) Priority: 30.06.2010 JP 2010149693
(43) Date of publication of application: 08.05.2013
(73) Proprietor: Panasonic Intellectual Property Management Co., Ltd., Osaka-shi, Osaka 540-6207 (JP)
(72) Inventor: MAKI Kenichi, Moriguchi-shi Osaka 570-8677 (JP); TOHODA Satoshi, Moriguchi-shi Osaka 570-8677 (JP); KUDOH Yoshiyuki, Moriguchi-shi Osaka 570-8677 (JP); HASHIMOTO Haruhisa, Moriguchi-shi Osaka 570-8677 (JP)
(74) Representative: Mewburn Ellis LLP
(86) International application number: PCT/JP2011/064933
(87) International publication number: WO 2012/002445

(56) References cited:
- EP-A1- 2 200 046
- EP-A1- 2 200 093
- WO-A1-2009/041506
- JP-A- 2008 288 333
- US-A1- 2007 186 968
- US-A1- 2008 121 265
- US-A1- 2009 032 081
- US-A1- 2009 044 856
- US-A1- 2010 108 141

## Description

### TECHNICAL FIELD

The invention relates to a solar cell module and a method for manufacturing the same.

### BACKGROUND ART

Solar cell modules have attracted greater attention in recent years as an energy source that is friendly to the environment.

In general, a solar cell module includes a plurality of solar cells. The plurality of solar cells are electrically connected in series or in parallel by a wiring material.

Conventionally, solder has been widely used for the adhesion between the solar cell and the wiring material. However, in order to bond the solar cell and the wiring material by using solder, it is necessary to melt solder. Therefore, the solar cell becomes hot in the bonding process. As a result, there is a possibility that the solar cell is damaged, or deformed.

In view of this issue, the adhesion between the solar cell and the wiring material using a conductive resin adhesive has been studied in recent years (for example, see Patent Document 1.)

When an adhesive resin such as a conductive resin adhesive is used for bonding the solar cell and the wiring material, the temperature can be kept low upon bonding, as opposed to using a solder for bonding. Therefore, damages or deformations etc. of the solar cell in the bonding process of the wiring material can be prevented.

US2007/186968 discloses a photovoltaic module that includes a plurality of semiconductor layers including a photoelectric conversion layer, a plurality of photovoltaic elements including a finger electrode for collecting generated currents, formed on the semiconductor layers on a side of a light receiving surface, and a tab electrode for electrically connecting the plurality of photovoltaic elements, in which the tab electrode is electrically connected to the finger electrode in a region corresponding to a power generation region of the photovoltaic element and bonded on the light receiving surface through an insulating bonding material.

EP2200093 discloses a member for conductor connection having an adhesive layer 3 formed on at least one side of a metal foil, wherein the metal foil comprises a plurality of projections of substantially equal height integrated with the metal foil, on the side on which an adhesive layer is formed, and the adhesive layer is formed to a substantially uniform thickness along the projections.

US2009/032081 discloses a method for manufacturing a solar cell module wherein the width of the connection region in which the wiring member and the connecting electrode are electrically connected is set to be larger than substantially half of the width of the wiring member in the thermocompression bonding process of the wiring member using an resin adhesive including particles onto the principal surface of the solar cell.

### PRIOR ART DOCUMENT

### PATENT DOCUMENT

Patent Document 1: Japanese Patent Application Publication No. 2009-295940

### SUMMARY OF THE INVENTION

### PROBLEM TO BE SOLVED BY THE INVENTION

Meanwhile, the standard of durability for solar cells to bear the repeated temperature changes, which is required for a solar cell module, has become higher in recent years.

The present invention is made in view of such issues. The purpose of the present invention is to improve durability against repeated changes in temperature in a solar cell module, in which a solar cell and a wiring material are bonded with a resin adhesive.

### MEANS FOR SOLVING THE PROBLEM

According to a first aspect of the present invention there is provided a solar cell module according to claim 1.

According to a second aspect of the present invention there is provided a method for manufacturing a solar cell module according to claim 4.

According to a third aspect of the present invention there is provided a method for manufacturing a solar cell module according to claim 5.

### EFFECTS OF THE INVENTION

According to the present invention, the durability against repeated changes in temperature is further improved in a solar cell module including a solar cell and a wiring material bonded with a resin adhesive.

### BRIEF DESCRIPTION OF THE DRAWINGS

[Fig.1] is a schematic cross-sectional view of a solar cell module according to an embodiment of the present invention.
[Fig.2] is a schematic plan view seen from a light-receiving surface side of the solar cell.
[Fig.3] is a schematic cross-sectional view taken along line III-III of Fig.2.
[Fig.4] is a schematic cross-sectional view for explaining a step for connecting a wiring material according to the embodiment of the present invention.
[Fig.5] is a schematic cross-sectional view for explaining a step for connecting wiring material according to a first modified example.
[Fig.6] is a schematic plan view seen from the light receiving surface side of the solar cell in a second modified example.
[Fig.7] is a schematic plan view seen from the light receiving surface side of the solar cell in a third modified example.
[Fig.8] is a graph showing the results of temperature cycle tests in each of Example 1 and Comparative Example 1.

### MODES FOR CARRYING OUT THE INVENTION

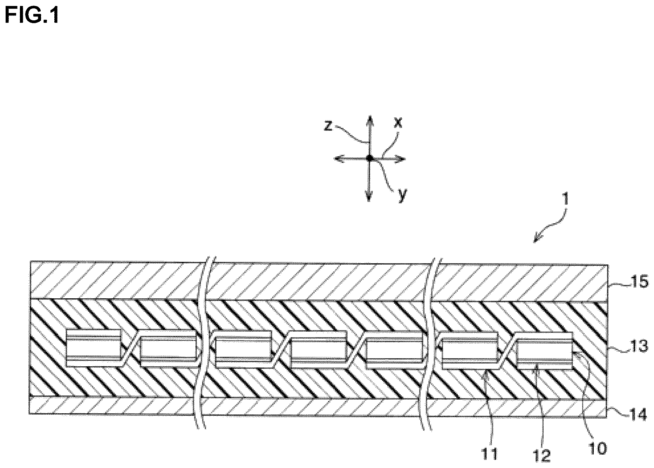

The following describes preferred embodiments of the invention referring to solar cell module 1 shown in Fig.1 as an example. Note that solar cell module 1 is a mere example, and the solar cell module according to the invention is not particularly limited to solar cell module 1.

In the drawings referred to in embodiments and modified examples, the same reference sign denote members having substantially the same function. The drawings referred to in embodiments and the like are schematic and ratios of dimensions and the like of an object in the drawings might be different from actual ratios of dimensions and the like. Moreover, the drawings also include objects having different ratios of dimensions. Therefore, specific ratios of dimensions and the like should be determined in consideration of the following description.

### (Schematic structure of solar cell module 1)

Fig.1 is a schematic cross-sectional view of solar cell module 1 according to an embodiment of the present invention.

The solar cell module 1 includes a plurality of solar cells 10 that are arranged along array direction x. The plurality of solar cells 10 are electrically connected by wiring material 11. Specifically, a plurality of solar cells 10 are electrically connected in series or in parallel by electrical connection between neighboring solar cells 10 by wiring material 11.

First and second protection members 14 and 15 are disposed in a light-receiving surface side and a back side of the plurality of solar cells 10. Sealing material 13 is provided between first protection member 14 and second protection member 15. The plurality of solar cells 10 are sealed by this sealing material 13.

Materials for sealing material 13, and first and second protection members 14, 15 are not particularly limited. For example, sealing material 13 may be formed by a resin having a light-transmitting property such as ethylene-vinyl acetate copolymer (EVA) and polyvinyl butyral (PVB).

First and second protection members 14, 15 may be formed, for example, with glass, resin or the like. Also, for example, one of first and second protection members 14, 15 may be formed by a resin film in which a metal foil such as aluminum foil is interposed. In this embodiment, first protection member 14 is disposed on the back side of solar cell 10, and is formed by a resin film in which the metal foil such as aluminum foil is interposed. Second protection member 15 is disposed on a light-receiving surface side of solar cell 10, and is formed by glass or transparent resin.

### (The structure of solar cell 10)

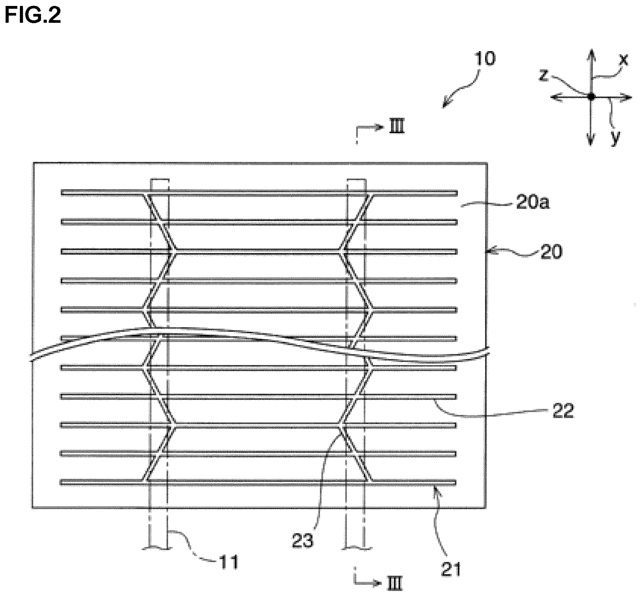

Fig.2 is a schematic plan view seen from the light-receiving surface side of the solar cell. Note that solar cell 10 described herein is a mere example. In the present invention, the type and structure of a solar cell is not limited to this configuration in any way.

Moreover, in this embodiment, one main surface of solar cell 10 is a light-receiving surface and the other main surface is a back surface. However, in the present invention, both main surfaces may be the light-receiving surface of the solar cell. In that case, each of first and second protection members 14, 15 preferably have a light-transmitting property.

### (Photoelectric conversion unit 20)

As shown in Fig. 2 solar cell 10 includes photoelectric conversion unit 20. Photoelectric conversion unit 20 generates carriers (electrons and holes) upon receiving light.

Photoelectric conversion unit 20 includes semiconductor material having a semiconductor junction such as a HIT junction (registered trademark), a p-n junction, or a p-i-n junction. Examples of semiconductor materials are crystalline semiconductors such as monocrystalline silicon and polycrystalline silicon, thin film semiconductors such as amorphous silicon, and compound semiconductors such as GaAs.

### (Electrode 21)

Electrode 21 is formed on light-receiving surface 20a of photoelectric conversion unit 20. Although not shown in the figure, electrode 21 is formed on the back surface of photoelectric conversion unit 20. As shown in Fig. 2, electrode 21 includes a plurality of finger electrodes 22, and a plurality of bus bars 23. Note that in this embodiment, the plurality of finger electrodes 22 and the plurality of bus bar 23 are integrally formed.

Each of the plurality of finger electrodes 22 extends parallel to each other in direction y, which is perpendicular to array direction x. The plurality of finger electrodes 22 are arranged parallel to each other along arrangement direction x.

Bus bar 23 is formed in a staggered array along arrangement direction x. This bus bar 23 is electrically connected to the plurality of finger electrodes 22.

### (Electrical connection of solar cell 10 by wiring material 11)

As shown in Fig. 1, solar cells 10 that are disposed adjacent to each other are electrically connected by wiring material 11. More specifically, one portion of wiring material 11 is electrically connected to electrode 21 of light-receiving surface side 20a of solar cell 10, and the other portion of wiring material 11 is electrically connected to electrode 21 on the back side of neighboring solar cell 10 that is adjacent to this solar cell 10. Thus neighboring solar cells 10 are electrically connected by wiring material 11.

Wiring material 11 is not particularly limited as long as it is conductive. For example, wiring material 11 may include a wiring material main body and a coating layer that covers the wiring material main body. The wiring material main body can be formed by, for example, Cu. The coating layer may be formed, for example, by metal such as Ag and an alloy such as solder.

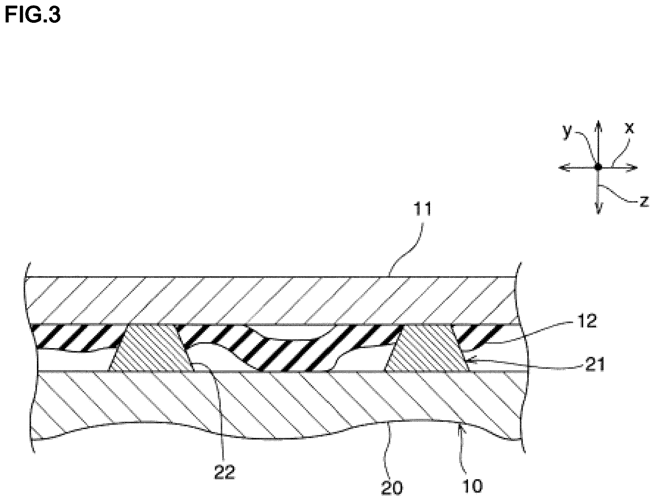

As shown in Figs. 1 and 3, wiring material 11 and solar cell 10 are bonded by resin adhesive 12. In the present embodiment, specifically, solar cell 10 and wiring material 11 are bonded by the resin adhesive 12 in a state where electrode 21 of solar cell 10 and wiring material 11 are in direct contact. Thus, in the present embodiment, electrode 21 and wiring material 11 are electrically connected by making direct contact with electrode 21 and wiring material 11. Resin adhesive 12 is formed to bridge a back surface of wiring material 11 and a side surface of electrode 21 thereby bonding each other. Furthermore, resin adhesive 12 is formed partially to reach a surface of photoelectric conversion unit 20 from the back surface of wiring material 11 via the side surface of electrode 21, thereby bonding these wiring material 11, electrode 21, and photoelectric conversion unit 20.

Resin adhesive 12 includes a resin having an adhesive property. Specific examples of the adhesive resin are, for instance, an epoxy resin, an acrylic resin, a polyimide resin, a phenol resin, an urethane resin, a silicone resin, and a mixture of at least two of these resins and a copolymer.

Resin adhesive 12 may have either an electrical conductivity or an insulating property. Examples of resin adhesive 12 having an electrical conductivity are, for instance, anisotropic conductive resins and the like including the above mentioned resins that contain conductive particles. Examples of conductive particles are metals such as nickel, copper, silver, aluminum, tin, and gold, as well as alloy particles including one or more of these metals, or insulating particles that are treated with a conductive coating process including a metal coating process or an alloy coating process.

Further, in the case where resin adhesive 12 has the insulating properties, it is also possible to form insulating adhesive 12 with the above-mentioned resins. Also, insulating adhesive 12 may be formed by the above-mentioned resins that contain insulating particles such as silica.

As shown in Fig. 3, in this embodiment, there is a region between wiring member 11 and solar cell 10 that is not filled with resin adhesive 12. That is, in between wiring material 11 and solar cell 10, there is a non-contiguous region where resin adhesive 12 is not located continuously from wiring material 11 to solar cell 10 in a direction opposing to wiring material 11 and solar cell 10. Further, this non-contiguous region is also present in portions adjacent to electrode 21.

### (Method for manufacturing solar cell module 1)

Next, a method for manufacturing solar cell module 1 is described in detail.

First, photoelectric conversion unit 20 is prepared. Note that photoelectric conversion unit 20 can be manufactured by conventional methods.

Next, solar cell 10 is completed by forming electrode 21 on each of light receiving surface 20a and the back surface of photoelectric conversion unit 20. The method of forming electrode 21 is not particularly limited. Electrode 21 may be formed, for example, by printing the conductive paste by a screen printing method.

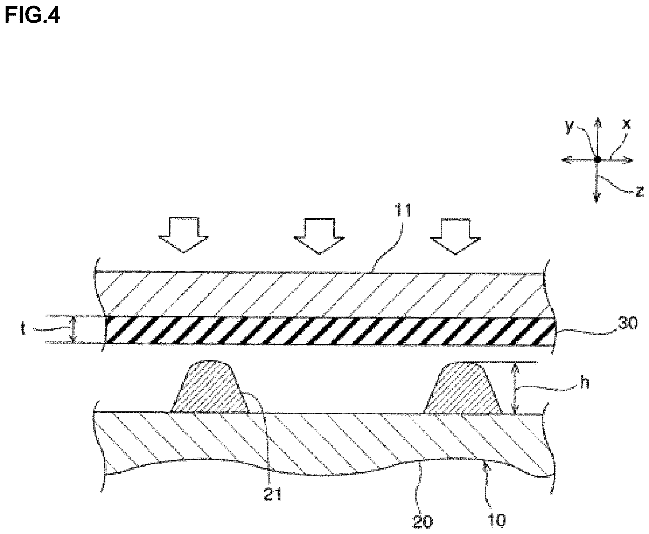

Next, a plurality of solar cells 10 prepared as described above are electrically connected by wiring material 11. Specifically, as shown in Fig. 4, while resin sheet 30 is disposed between solar cell 10 and wiring material 11, solar cell 10 and wiring material 11 are pressed together until wiring material 11 and electrode 21 are in direct contact. Then, resin sheet 30 is cured in this state, thereby bonding solar cell 10 and wiring material 11. The resultant cured product of resin sheet 30 becomes resin adhesive 12.

Here, in this embodiment, resin sheet 30 having thickness t that is smaller than height h of electrode 21 is used. Therefore, as shown in Fig. 3, the non-contiguous region is formed.

Note that resin sheet 30 can be formed by, for example, energy-ray-curable resins such as a thermosetting resin and a photo-curable resin. In this case, resin sheet 30 can be cured by energy ray curing. Furthermore, resin sheet 30 can also be formed by, for example, a thermoplastic resin. In this case, resin sheet 30 is temporarily softened by heating, and then cured by cooling.

By repeating the adhesion between solar cell 10 and wiring material 11 as described above, the plurality of solar cells 10 are electrically connected.

Next, a resin sheet such as an EVA sheet is disposed on second protection member 15. The plurality of solar cells 10 that are connected by wiring material 11 are disposed on the resin sheet. A resin sheet such as EVA sheet is disposed thereon, and first protection member 14 is further disposed thereon. After these are tentatively pressure-bonded by heat and pressure under the atmosphere of a reduced pressure, the resin sheet is cured by heating again. Solar cell module 1 is produced through the steps described above.

Note that a terminal box and a metal frame and the like may be installed if necessary.

As described above, in the area between wiring material 11 and solar cell 10 in this embodiment, the non-contiguous region where resin adhesive 12 is not continuously located from wiring material 11 to solar cell 10 is provided in opposing direction z. Namely, wiring material 11 is bonded to solar cell 10 partially by resin adhesive 12, rather than wiring material and solar cell 10 are entirely adhered by resin adhesive 12. Therefore, the effects of thermal stress caused by repeated temperature change due to differences in thermal expansion coefficients between wiring member 11 and solar cell 10 during routine use can be mitigated. Accordingly, problems such as a separation of wiring material 11 can be prevented. As a result, the durability of solar cell module 1 can be improved.

In this embodiment, the non-contiguous region where resin adhesive 12 is not continuously located from wiring material 11 to solar cell 10 is provided in opposing direction z. By providing the non-contiguous region, the separation of the wiring material from the solar cell due to repeated changes in temperature can be prevented. Accordingly, a high durability can be achieved.

The volume percent of the non-contiguous region occupied in the area between wiring material 11 and solar cell 10 is preferably not less than approximately 20% of the area. However, if the volume percent of the non-contiguous region to the region between wiring material 11 and solar cell 10 becomes too great, the bond strength between wiring material 11 and electrode 21 may become too weak. Thus, the volume percent of the non-contiguous region occupied in the area between wiring material 11 and solar cell 10 is preferably not more than 80%.

### (First modified example)

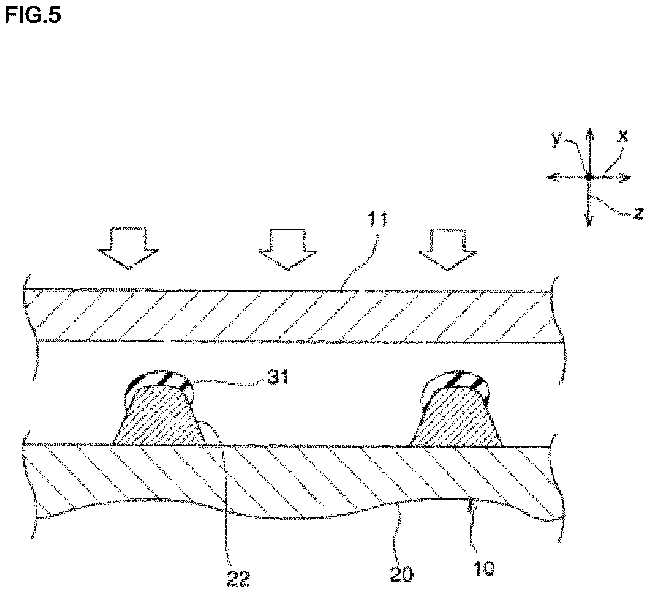

Fig. 5 is a schematic cross-sectional view for explaining a step for connecting wiring material according to a first modified example of the embodiment.

In the above embodiment, an example of forming a non-contiguous region is described by using thin resin sheet 30 having thickness t that is smaller than height h of electrode 21. However, in the present invention, the method for forming the non-contiguous region is not limited to this method.

For example, as shown in Fig. 5, resin adhesive 12 can be formed by resin 31 by applying resin 31 to the top portion of electrode 21. Even in this case, the non-contiguous region can be suitably formed.

### (Second and third modified examples)

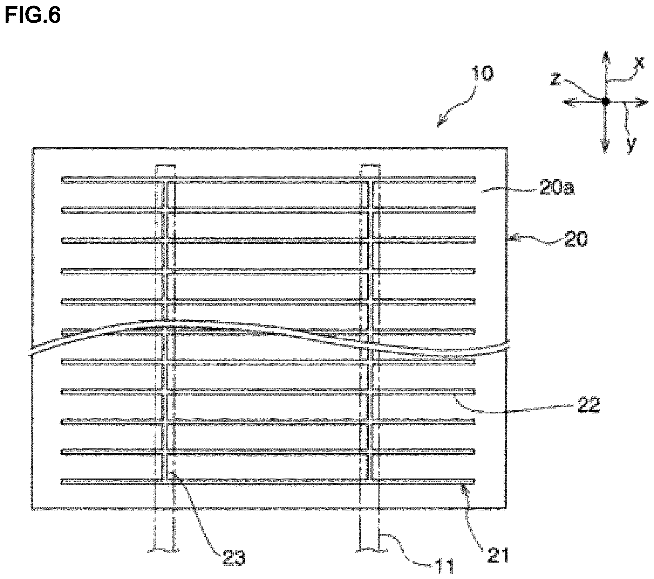

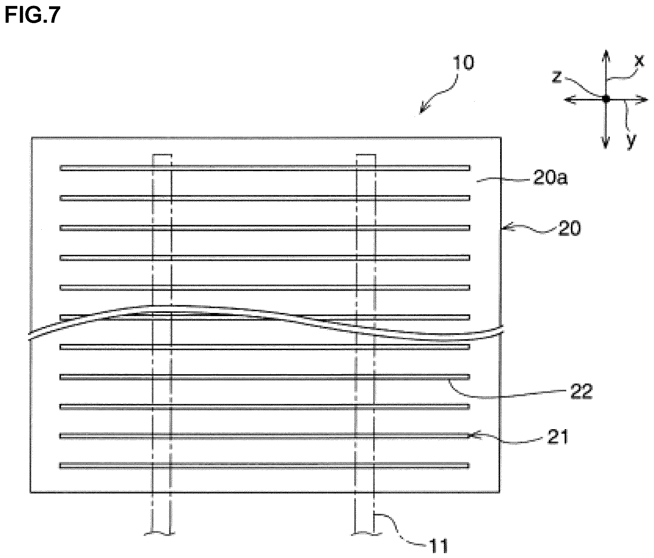

Fig. 6 is a schematic plan view seen from the light receiving surface side of the solar cell in a second modified example. Fig. 7 is a schematic plan view seen from the light receiving surface side of the solar cell in a third modified example.

In the above embodiment, an example in which electrode 21 includes the plurality of bus bar formed in a staggered manner and the plurality of finger electrodes 22 is described. However, in the present invention, the configuration of the electrode is not limited to this configuration.

As shown in Fig. 6, for example, electrode 21 may include the plurality of bus bar 23 formed in straight lines and the plurality of finger electrodes 22.

As shown in Fig. 7, for example, electrode 21 may be formed only by the plurality of finger electrodes 22, without providing bus bars.

Hereinafter, the present invention will be described in more detail based on specific examples, however, the present invention is not limited to the following examples.

### (Example 1 and Comparative Example 1)

In Example 1, three solar cell modules having the same configuration as the above embodiment are prepared in accordance with the method described in the above embodiment, where the ratio of thickness t of resin sheet 30 to height h of electrode 21 (t / h) is approximately 0.8.

Meanwhile, in Comparative Example 1, three solar cell modules are produced in the same manner as Example 1 except that the ratio of thickness t of the resin sheet to height h of electrode (t / h) is approximately 1.2.

As a result of observing the cross-section of a solar cell module produced in each of Example 1 and Comparative Example 1 with an electronic microscope, formation of a non-contiguous region as described in the above embodiment is confirmed in Example 1. In contrast, in Comparative Example 1, the non-contiguous region is either not formed or a very little amount of the non-contiguous region is formed if any, and it is confirmed that the area between the solar cell and wiring material is essentially filled with the resin.

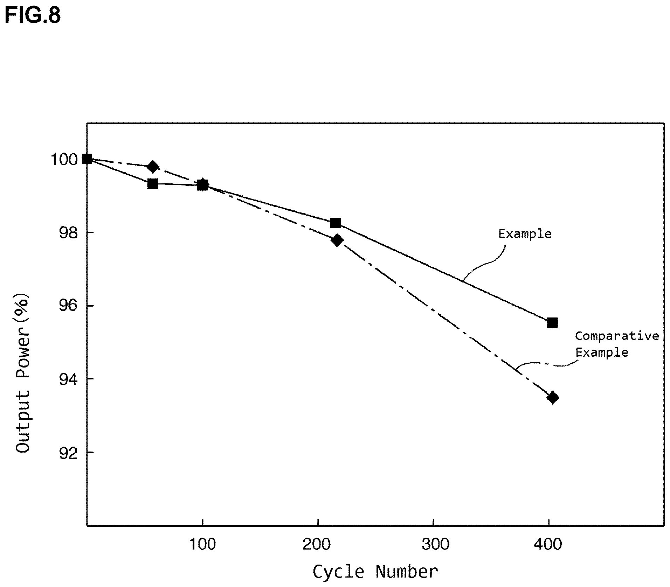

Next, the temperature cycle test is conducted using each of the three solar cell modules prepared in each of Example 1 and Comparative Example 1. In the temperature cycle test, 400 cycles of the test are carried out, in which one cycle constitutes a change of temperature from a high temperature (90 °C) to a low temperature (-40 °C) or from a low temperature to a high temperature. Then, measurements for the output power are taken after 0 cycles, 50 cycles, 100 cycles, 200 cycles and 400 cycles, respectively. Then, an average output power of three samples is calculated in each of Example 1 and Comparative Example 1. The results are shown in Fig. 8. Note that the output power shown in Fig. 8 is a normalized value in which an output power before conducting each of the temperature cycle tests is set as 100.

As shown in the results in Fig. 8, the output power reduction due to the repeated temperature change is smaller in Example 1 in which a non-contiguous region is formed than in Comparative Example 1 in which a non-contiguous region is not formed.

### EXPLANATION OF THE REFERENCE NUMERALS

1 ...solar cell module
10 ...solar cell
11 ...wiring material
12 ...resin adhesive
13 ...sealing material
14 ...first protection member
15 ...second protection member
20 ...photoelectric conversion unit
20a ...light-receiving surface of the photoelectric conversion unit
21 ...electrode
22 ...finger electrode
23 ...bus bar
30 ...resin sheet

## Claims

1. A solar cell module (1) comprising:
a plurality of solar cells wherein at least one solar cell (10) includes a photoelectric conversion unit (20) and an electrode (21) formed on a light receiving surface of the photoelectric conversion unit (20);
a wiring material (11) that electrically connects the plurality of solar cells ; and
a resin adhesive (12), wherein the solar cell (10) and the wiring material (11) are bonded by the resin adhesive (12),
**characterized in that**:
the electrode (21) is in direct contact with the wiring material (11), and
a non-contiguous adhesive resin region is present in an area between the wiring material (11) and the solar cell (10) in which the resin adhesive (12) is not located continuously from the wiring material (11) to the solar cell (10) in a direction in which the wiring material (11) and the solar cell (10) oppose each other, such that the resin adhesive (12) is formed so as to partially reach the surface of the photoelectric conversion unit (20) from a back surface of the wiring material (11) via a side surface of the electrode (21), such that the wiring material (11) is only partially bonded to the solar cell (10) by the resin adhesive (12).

2. The solar cell module (1) according to claim 1,
wherein the non-contiguous adhesive resin region is present adjacent to the electrode (21).

3. The solar cell module (1) according to any one of claims 1 to : 2,
wherein a volume percent of the non-contiguous adhesive resin region that occupies the area between the wiring material (11) and the solar cell (10) is no less than 20% and no more than 80%.

4. A method for manufacturing a solar cell module (1) comprising a plurality of solar cells wherein at least one solar cell (10) include a photoelectric conversion unit (20) and an electrode (21) formed on a light receiving surface of the photoelectric conversion unit (20),
a wiring material (11) that electrically connects the plurality of solar cells , and
a resin adhesive (12) that adheres the wiring material (11) and the electrode (21) of the at least one solar cell (10), wherein
the electrode (21) is in direct contact with the wiring material (11),
the method comprising:
electrically connecting the electrode (21) and the wiring material (11) by pressing the solar cell (10) and the wiring material (11) together while a resin adhesive material (30) having a thinner thickness than a height of the electrode (21) is disposed in between the solar cell (10) and the wiring material (11); and
curing the resin adhesive material (30) to thereby bond the solar cell (10) and the wiring material (11) in a manner that a non-contiguous adhesive resin region is present between the wiring material (11) and the solar cell (10) in which the resin adhesive (12) is not located continuously from the wiring material (11) to the solar cell (10) in a direction in which the wiring material (11) and the solar cell (10) oppose each other, such that the cured resin adhesive material is formed so as to partially reach the surface of the photoelectric conversion unit (20) from a back surface of the wiring material (11) via a side surface of the electrode (21) , such that the wiring material (11) is only partially bonded to the solar cell (10) by the resin adhesive (12).

5. A method for manufacturing a solar cell module (1) including a plurality of solar cells wherein at least one solar cell (10) includes a photoelectric conversion unit (20) and an electrode (21) formed on a light receiving surface of the photoelectric conversion unit (20),
a wiring material (11) that electrically connects the plurality of solar cells, and
a resin adhesive (12) that adheres the wiring material (11) and the electrode (21) of the at least one solar cell (10), wherein
the electrode (21) is in direct contact with the wiring material (11),
the method comprising:
applying a resin adhesive material on a top portion of the electrode (21);
pressing the solar cell (10) and the wiring material (11) together in a state that the wiring material (11) is disposed on the electrode (21) whose top portion is coated with the resin adhesive material; and
curing the resin adhesive material to thereby electrically connect the electrode (21) and the wiring material (11), as well as to bond the solar cell (10) and the wiring material (11) in a manner that a non-contiguous adhesive resin region is present between the wiring material (11) and the solar cell (10) in which the resin adhesive (12) is not located continuously from the wiring material (11) to the solar cell (10) in a direction in which the wiring material (11) and the solar cell (10) oppose each other, such that the cured resin adhesive material is formed so as to partially reach the surface of the photoelectric conversion unit (20) from a back surface of the wiring material (11) via a side surface of the electrode, such that the wiring material (11) is only partially bonded to the solar cell (10) by the resin adhesive (12).

## Patentansprüche

1. Solarzellenmodul (1), umfassend:
eine Vielzahl von Solarzellen, wobei zumindest eine Solarzelle (10) eine photoelektrische Umwandlungseinheit (20) und eine Elektrode (21), die auf einer lichtempfangenden Oberfläche der photoelektrischen Umwandlungseinheit (20) ausgebildet ist, umfasst;
ein Verdrahtungsmaterial (11), das die Vielzahl von Solarzellen elektrisch verbindet; und
einen Harzklebstoff (12), wobei die Solarzelle (10) und das Verdrahtungsmaterial (11) durch den Harzklebstoff (12) haftverbunden sind,
**dadurch gekennzeichnet, dass**:
die Elektrode (21) in direktem Kontakt mit dem Verdrahtungsmaterial (11) steht, und
ein nicht zusammenhängender Klebeharzbereich in einem Bereich zwischen dem Verdrahtungsmaterial (11) und der Solarzelle (10) vorhanden ist, in der der Harzklebstoff (12) nicht kontinuierlich von dem Verdrahtungsmaterial (11) zu der Solarzelle (10) in einer Richtung angeordnet ist, in der das Verdrahtungsmaterial (11) und die Solarzelle (10) einander gegenüberliegen, so dass der Harzklebstoff (12) so gebildet ist, dass er die Oberfläche der photoelektrischen Umwandlungseinheit (20) von einer Rückseite des Verdrahtungsmaterials (11) über eine Seitenfläche der Elektrode (21) teilweise erreicht, so dass das Verdrahtungsmaterial (11) nur teilweise durch den Harzklebstoff (12) mit der Solarzelle (10) haftverbunden ist.

2. Solarzellenmodul (1) nach Anspruch 1,
wobei der nicht zusammenhängende Klebeharzbereich benachbart zu der Elektrode (21) vorhanden ist.

3. Solarzellenmodul (1) nach einem der Ansprüche 1 bis 2,
wobei ein Volumenprozent des nicht zusammenhängenden Klebeharzbereichs, der den Bereich zwischen dem Verdrahtungsmaterial (11) und der Solarzelle (10) einnimmt, nicht weniger als 20 % und nicht mehr als 80 % beträgt.

4. Verfahren zum Herstellen eines Solarzellenmoduls (1), umfassend
eine Vielzahl von Solarzellen, wobei zumindest eine Solarzelle (10) eine photoelektrische Umwandlungseinheit (20) und eine Elektrode (21), die auf einer lichtempfangenden Oberfläche der photoelektrischen Umwandlungseinheit (20) ausgebildet ist, umfasst,
ein Verdrahtungsmaterial (11), das die Vielzahl von Solarzellen elektrisch verbindet, und
einen Harzklebstoff (12), der das Verdrahtungsmaterial (11) und die Elektrode (21) der zumindest einen Solarzelle (10) miteinander haftverbindet, wobei
die Elektrode (21) in direktem Kontakt mit dem Verdrahtungsmaterial (11) steht,
wobei das Verfahren Folgendes umfasst:
das elektrische Verbinden der Elektrode (21) mit dem Verdrahtungsmaterial (11), indem die Solarzelle (10) und das Verdrahtungsmaterial (11) aneinander gepresst werden, während ein Harzklebematerial (30) mit einer dünneren Dicke als eine Höhe der Elektrode (21) zwischen der Solarzelle (10) und dem Verdrahtungsmaterial (11) angeordnet wird; und
das Aushärten des Harzklebematerials (30), um dadurch die Solarzelle (10) und das Verdrahtungsmaterial (11) in einer Weise haftzuverbinden, dass ein nicht zusammenhängender Klebeharzbereich zwischen dem Verdrahtungsmaterial (11) und der Solarzelle (10) vorhanden ist, in dem der Harzklebstoff (12) nicht kontinuierlich von dem Verdrahtungsmaterial (11) zu der Solarzelle (10) in einer Richtung angeordnet wird, in der das Verdrahtungsmaterial (11) und die Solarzelle (10) einander gegenüberliegen, so dass das ausgehärtete Harzklebematerial so gebildet ist, dass es die Oberfläche der photoelektrischen Umwandlungseinheit (20) von einer Rückseite des Verdrahtungsmaterials (11) über eine Seitenfläche der Elektrode (21) teilweise erreicht, so dass das Verdrahtungsmaterial (11) nur teilweise durch den Harzklebstoff (12) mit der Solarzelle (10) haftverbunden ist.

5. Verfahren zum Herstellen eines Solarzellenmoduls (1), umfassend
eine Vielzahl von Solarzellen, wobei zumindest eine Solarzelle (10) eine photoelektrische Umwandlungseinheit (20) und eine Elektrode (21), die auf einer lichtempfangenden Oberfläche der photoelektrischen Umwandlungseinheit (20) ausgebildet ist, umfasst,
ein Verdrahtungsmaterial (11), das die Vielzahl von Solarzellen elektrisch verbindet, und
einen Harzklebstoff (12), der das Verdrahtungsmaterial (11) und die Elektrode (21) der zumindest einen Solarzelle (10) miteinander haftverbindet, wobei
die Elektrode (21) in direktem Kontakt mit dem Verdrahtungsmaterial (11) steht,
wobei das Verfahren Folgendes umfasst:
das Aufbringen eines Harzklebematerials auf einen oberen Abschnitt der Elektrode (21);
das Aneinanderpressen der Solarzelle (10) und des Verdrahtungsmaterials (11) in einem Zustand, in dem das Verdrahtungsmaterial (11) auf der Elektrode (21), deren oberer Abschnitt mit dem Harzklebematerial beschichtet ist, angeordnet ist; und
das Aushärten des Harzklebematerials, um dadurch die Elektrode (21) mit dem Verdrahtungsmaterial (11) elektrisch zu verbinden, sowie die Solarzelle (10) und das Verdrahtungsmaterial (11) in einer Weise zu verbinden, dass ein nicht zusammenhängender Klebeharzbereich zwischen dem Verdrahtungsmaterial (11) und der Solarzelle (10) vorhanden ist, in dem der Harzklebstoff (12) nicht kontinuierlich von dem Verdrahtungsmaterial (11) zu der Solarzelle (10) in einer Richtung angeordnet ist, in der das Verdrahtungsmaterial (11) und die Solarzelle (10) einander gegenüberliegen, so dass das ausgehärtete Harzklebematerial so gebildet ist, dass es die Oberfläche der photoelektrischen Umwandlungseinheit (20) von einer Rückseite des Verdrahtungsmaterials (11) über eine Seitenfläche der Elektrode teilweise erreicht, so dass das Verdrahtungsmaterial (11) nur teilweise durch den Harzklebstoff (12) mit der Solarzelle (10) haftverbunden ist.

## Revendications

1. Module de cellule solaire (1) comprenant :
une pluralité de cellules solaires, dans lequel au moins une cellule solaire (10) comprend une unité de conversion photoélectrique (20) et une électrode (21) formée sur une surface de réception de lumière de l'unité de conversion photoélectrique (20) ;
un matériau de câblage (11) qui relie électriquement la pluralité de cellules solaires ; et
un adhésif à base de résine (12), dans lequel la cellule solaire (10) et le matériau de câblage (11) sont liés par l'adhésif à base de résine (12),
**caractérisé en ce que** :
l'électrode (21) est en contact direct avec le matériau de câblage (11), et
une zone de résine adhésive non contiguë est présente dans une zone située entre le matériau de câblage (11) et la cellule solaire (10) dans laquelle l'adhésif à base de résine (12) ne se trouve pas en continu entre le matériau de câblage (11) et la cellule solaire (10) dans une direction dans laquelle le matériau de câblage (11) et la cellule solaire (10) sont opposés l'un à l'autre, de sorte que l'adhésif à base de résine (12) soit formé de façon à atteindre partiellement la surface de l'unité de conversion photoélectrique (20) depuis une surface arrière du matériau de câblage (11) via une surface latérale de l'électrode (21), de sorte que le matériau de câblage (11) ne soit que partiellement relié à la cellule solaire (10) par l'adhésif à base de résine (12).

2. Module de cellule solaire (1) selon la revendication 1, dans lequel la zone de résine adhésive non contiguë est présente de manière adjacente à l'électrode (21) .

3. Module de cellule solaire (1) selon l'une quelconque des revendications 1 à 2, dans lequel un pourcentage de volume de la zone de résine adhésive non contiguë qui occupe la zone située entre le matériau de câblage (11) et la cellule solaire (10) est non inférieur à 20% et non supérieur à 80%.

4. Procédé de fabrication d'un module de cellule solaire (1) comprenant une pluralité de cellules solaires, dans lequel au moins une cellule solaire (10) comprend une unité de conversion photoélectrique (20) et une électrode (21) formée sur une surface de réception de lumière de l'unité de conversion photoélectrique (20),
un matériau de câblage (11) qui relie électriquement la pluralité de cellules solaires, et
un adhésif à base de résine (12) qui colle le matériau de câblage (11) et l'électrode (21) de la au moins une cellule solaire (10), dans lequel
l'électrode (21) est en contact direct avec le matériau de câblage (11),
le procédé comprenant :
la liaison électrique de l'électrode (21) et du matériau de câblage (11) en appuyant sur la cellule solaire (10) et le matériau de câblage (11) ensemble pendant qu'un matériau adhésif à base de résine (30) ayant une épaisseur inférieure à une hauteur de l'électrode (21) est disposé entre la cellule solaire (10) et le matériau de câblage (11) ; et
le durcissement du matériau adhésif à base de résine (30) afin de lier la cellule solaire (10) et le matériau de câblage (11) de sorte qu'une zone de résine adhésive non contiguë soit présente entre le matériau de câblage (11) et la cellule solaire (10), dans lequel l'adhésif à base de résine (12) ne se trouve pas en continu entre le matériau de câblage (11) et la cellule solaire (10) dans une direction dans laquelle le matériau de câblage (11) et la cellule solaire (10) sont opposés l'un à l'autre, de sorte que le matériau adhésif à base de résine durci soit formé de façon à atteindre partiellement la surface de l'unité de conversion photoélectrique (20) depuis une surface arrière du matériau de câblage (11) via une surface latérale de l'électrode (21), de sorte que le matériau de câblage (11) ne soit que partiellement relié à la cellule solaire (10) par l'adhésif à base de résine (12).

5. Procédé de fabrication d'un module de cellule solaire (1) comprenant une pluralité de cellules solaires, dans lequel au moins une cellule solaire (10) comprend une unité de conversion photoélectrique (20) et une électrode (21) formée sur une surface de réception de lumière de l'unité de conversion photoélectrique (20),
un matériau de câblage (11) qui relie électriquement la pluralité de cellules solaires, et
un adhésif à base de résine (12) qui colle le matériau de câblage (11) et l'électrode (21) de la au moins une cellule solaire (10), dans lequel
l'électrode (21) est en contact direct avec le matériau de câblage (11),
le procédé comprenant :
l'application d'un matériau adhésif à base de résine sur une partie supérieure de l'électrode (21) ;
le fait d'appuyer sur la cellule solaire (10) et le matériau de câblage (11) ensemble, dans un état dans lequel le matériau de câblage (11) est disposé sur l'électrode (21) dont la partie supérieure est recouverte avec le matériau adhésif à base de résine ; et
le durcissement du matériau adhésif à base de résine afin de relier électriquement l'électrode (21) et le matériau de câblage (11), et de relier la cellule solaire (10) et le matériau de câblage (11) de sorte qu'une zone de résine adhésive non contiguë soit présente entre le matériau de câblage (11) et la cellule solaire (10), dans lequel l'adhésif à base de résine (12) ne se trouve pas en continu entre le matériau de câblage (11) et la cellule solaire (10) dans une direction dans laquelle le matériau de câblage (11) et la cellule solaire (10) sont opposés l'un à l'autre, de sorte que le matériau adhésif à base de résine durci soit formé de façon à atteindre partiellement la surface de l'unité de conversion photoélectrique (20) depuis une surface arrière du matériau de câblage (11) via une surface latérale de l'électrode, de sorte que le matériau de câblage (11) ne soit que partiellement relié à la cellule solaire (10) par l'adhésif à base de résine (12).
